(19) Europäisches Patentamt
European Patent Office
Office européen des brevets

(11) **EP 3 836 337 A1**

(12) **EUROPÄISCHE PATENTANMELDUNG**

(43) Veröffentlichungstag:
**16.06.2021  Patentblatt 2021/24**

(51) Int Cl.:
*H02J 3/38* (2006.01)   *H02P 21/00* (2016.01)

(21) Anmeldenummer: **20205955.6**

(22) Anmeldetag: **05.11.2020**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
**KH MA MD TN**

(30) Priorität: **10.12.2019   DE 102019133823**

(71) Anmelder: **Wobben Properties GmbH**
**26607 Aurich (DE)**

(72) Erfinder:
• **ROSSO, Roberto**
  **26605 Aurich (DE)**
• **ENGELKEN, Sönke**
  **28209 Bremen (DE)**
• **LISERRE, Marco**
  **24143 Kiel (DE)**

(74) Vertreter: **Eisenführ Speiser**
**Patentanwälte Rechtsanwälte PartGmbB**
**Postfach 10 60 78**
**28060 Bremen (DE)**

(54) **VERFAHREN ZUR STROMBEGRENZUNG EINER VIRTUELLEN SYNCHRONMASCHINE, INSBESONDERE WÄHREND EINES NETZFEHLERS**

(57)     Die vorliegende Erfindung betrifft ein Steuermodul eines Umrichters, insbesondere eines Leistungsumrichters einer Windenergieanlage, das dazu eingerichtet ist, den Umrichter so anzusteuern, dass der Umrichter ein Verhalten einer Synchronmaschine emuliert, umfassend: einen, insbesondere inneren, Regelkreis, der eine, insbesondere einstellbare, virtuelle Admittanz aufweist, mittels derer der Umrichter angesteuert wird, um das Verhalten der Synchronmaschine zu emulieren.

Fig. 5

EP 3 836 337 A1

**Beschreibung**

Die vorliegende Erfindung betrifft ein Steuermodul eines Umrichters, insbesondere eines Leistungsumrichters einer Windenergieanlage, das dazu eingerichtet ist, den Umrichter so anzusteuern, dass der Umrichter ein Verhalten einer Synchronmaschine emuliert.

Ferner betrifft die vorliegende Erfindung eine, ein solches Steuermodul aufweisende Steuereinheit, ein, ein solches Steuermodul aufweisenden Umrichter sowie ein Verfahren zum Steuern desselbigen und eine, ein solches Steuermodul aufweisende und/oder ein solches Verfahren ausführende Windenergieanlage.

Durch die zunehmende Verdrängung konventioneller, synchrongeneratorgetriebener Kraftwerke durch regenerative, umrichterbasierte Erzeuger, verlieren klassische Synchrongenerator immer mehr an Einfluss innerhalb des elektrischen Versorgungsnetzes.

Durch diesen Rückgang an Synchrongeneratoren kommt es ebenfalls zu einer Abnahme der konventionellen, das elektrische Versorgungsnetz stabilisierenden Schwungmassen.

Da die Auswirkungen einer solchen Änderung innerhalb des elektrischen Versorgungsnetzes nahezu unerforscht sind, gibt es Überlegungen die Umrichter der regenerativen Erzeuger so zu betreiben, dass sie am elektrischen Versorgungsnetz wie eine Synchronmaschine wirken. Mit anderen Worten sollen die Umrichter das Verhalten einer Synchronmaschine emulieren, ohne dabei die Vorzüge der Stromrichtertechnik zu verlieren. Solche so betriebenen Umrichter werden auch als virtuelle Synchronmaschine bezeichnet.

In den letzten Jahren wurden hierzu verschiedenste Regelverfahren für Synchronmaschinenemulationen vorgeschlagen.

Einige dieser Verfahren, wie bspw. in R. Rosso, J. Cassoli, G. Buticchi, S. Engelken, and M. Liserre, "Robust stability analysis of LCL filter based synchronverter under different grid conditions," IEEE Trans. Power Electron., 2018, doi: 10.11 09/TPEL.2018.2867040 gezeigt, weisen sogar Vorteile gegenüber Standard etablierten Umrichterregelverfahren auf, insbesondere an sogenannten schwachen Netzen, also Netze mit geringer Kurzschlussleistung, bspw. einer short circuit ratio (SCR) < 4.

Nachteilig an den bisher bekannten Verfahren zum Emulieren einer Synchronmaschine mittels eines Umrichters ist, dass diese nicht für etwaige, im elektrischen Versorgungsnetz auftretende Netzfehler ausgelegt sind.

Das Deutsche Patent- und Markenamt hat in der Prioritätsanmeldung zur vorliegenden Anmeldung folgenden Stand der Technik recherchiert: US 2014/0049228 A1, US 2014/0049233 A1, Artikel von L. Marin et al.: "Stability Analysis of a Grid-Connected VSC Controlled by SPC", 7th International Conference on Renewable Energy Research and Applications, Paris 2018, Seiten 1209-1214, Artikel von Weiyi Zhang et al.: "Start-Up of Virtual Synchronous Machine: Methods and Experimental Comparison", 2nd IEEE Conference on Energy Internet Internet and Energy System Integration (EI2), Beijing, 2018, Seiten 1-9, GB 2 554 954 A, WO 2019/129864 A1, Artikel von Roberto Rosso et al.: "Robust stability analysis of LCL filter based synchronverter under different grid conditions", IEEE Transactions on Power Electronics (T-PEL), Bd. 34, 2019, H. 6, Seiten 5842-5853.

Aufgabe der vorliegenden Erfindung ist es daher, zumindest eines der oben genannten Probleme zu adressieren, insbesondere soll eine Regelverfahren zur Beherrschung von Netzfehlern für virtuelle Synchronmaschinen vorgeschlagen werden, bevorzugt um die Eigenschaften einer realen Synchronmaschine auch unter einem Netzfehler und den Randbedingungen der Hardwareeigenschaften des Umrichters weiterhin reproduzieren zu können.

Erfindungsgemäß wird somit ein Steuermodul eines Umrichters, insbesondere eines Leistungsumrichters einer Windenergieanlage vorgeschlagen, das dazu eingerichtet ist, den Umrichter so anzusteuern, dass der Umrichter ein Verhalten einer Synchronmaschine emuliert, umfassend einen, insbesondere inneren, Regelkreis, der eine, insbesondere einstellbare, virtuelle Admittanz aufweist, mittels derer der Umrichter angesteuert wird, um das Verhalten der Synchronmaschine zu emulieren.

Das Steuermodul ist somit dazu eingerichtet, den Umrichter wie eine virtuelle Synchronmaschine zu betrieben, insbesondere so, dass der Umrichter an einem elektrischen Versorgungsnetz statisch wie dynamisch wie eine Synchronmaschine erscheint.

Sofern nachstehend von virtuellen Werten gesprochen wird, wie bspw. virtuelle Polradspannung, sind hierunter insbesondere die Werte zu verstehen, die in der Umrichteransteuerung den Werten einer normalen Synchronmaschine entsprechen. Die Steuerung des Umrichters erfolgt dabei insbesondere über bzw. mittels einer virtuellen Admittanz, die bspw. in einem inneren Regelkreis, bevorzugt einem Stromregelkreis, verwendet wird.

Der Regelkreis umfasst bspw. einen Spannungsabgleich zwischen einer am Anschlusspunkt des Umrichters erfassten Netzspannung und der virtuellen Polradspannung der virtuellen Synchronmaschine, dessen Ergebnis über die virtuelle Admittanz geführt wird, um einen Stromsollwert für den Umrichter zu erzeugen.

Durch die Verwendung einer virtuellen Admittanz ist es insbesondere möglich, die Stromamplituden der virtuellen Synchronmaschine einzustellen, insbesondere so, dass die, in einem Netzfehlerfall durch die virtuelle Synchronmaschine generierte Stromamplitude nicht die Randbedingungen der Umrichterhardware überschreitet.

Dem liegt die Annahme zu Grunde, dass bei der Emulation, genauso wie bei einer realen Synchronmaschine, während eines Netzfehlers erheblich überhöhte (Strom-)Amplituden auftreten können, die ein Vielfaches des Nennwertes des Statorstromes aufweisen. Ein solches Verhalten könnte aber nur reproduziert werden, wenn der Umrichter entsprechend für diese Ströme überdimensioniert wäre.

Die vorliegende Erfindung hingegen sieht vor, diese Ströme mittels einer virtuellen Admittanz einzustellen.

In einer besonders bevorzugten Ausführungsform ist die virtuelle Admittanz, bspw. mittels einer Admittanzregelung einstellbar, d.h. der Wert der virtuellen Admittanz kann im laufenden Betrieb verändert werden, und insbesondere an etwaige Netz- und/oder Hardwareanforderungen angepasst werden.

Besonders vorteilhaft bei der Verwendung einer virtuellen Admittanz ist zudem, dass sowohl das Verhalten einer Spannungsquelle reproduziert werden kann als auch, dass die Kontrolle über die Umrichterströme gewährleistet ist.

Vorzugsweise ist die virtuelle Admittanz definiert ist als:

$$Y_s(S) = \frac{1}{Z_{virt}(S)} = \frac{1}{R_{virt} + s\, L_{virt}},$$

wobei $Z_{virt}(S)$ eine virtuelle Impedanz ist und $R_{virt}$ ein entsprechender ohmscher Anteil der virtuellen Impedanz ist und $L_{virt}$ ein entsprechender induktiver Anteil der virtuellen Impedanz und s ein Laplace-Operator ist.

Hierdurch ist es insbesondere möglich, sowohl den Realteil als auch den Imaginärteil des Stromes zu steuern, bspw. durch Vorgabe eines ohmschen Anteils $R_{virt}$ und/oder durch Vorgabe eines induktiven Anteils $L_{virt}$ der virtuellen Admittanz $Y_s(S)$.

Bevorzugt sind dabei sowohl der ohmsche Anteil $R_{virt}$ als auch der induktive Anteil $L_{virt}$ im laufenden Betriebs veränderbar, bspw. durch eine Admittanzregelung, die dazu eingerichtet ist, die virtuelle Admittanz $Y_s(S)$ zu verändern, insbesondere mittels bestimmter Werte $R_{virt\_f}$, $L_{virt\_f}$, die für den ohmschen Anteil $R_{virt}$ und für den induktiven Anteil $L_{virt}$ berechnet werden.

Vorzugsweise erzeugt die virtuelle Admittanz $Y_s(S)$ einen ersten Stromsollwert i*.

Es wird somit insbesondere vorgeschlagen, dass die virtuelle Admittanz Bestandteil eines Stromregelkreises ist, der bevorzugt dazu verwendet wird, einen Stromsollwert für den Umrichter zu erzeugen.

Vorzugsweise weist der, insbesondere innere, Regelkreis ferner einen Spannungsabgleich auf, der eine Differenz zwischen einer virtuellen Polradspannung e* und einer am Anschlusspunkt des Umrichters gemessene Spannung $V_{PCC}$ bildet, und die Differenz der virtuellen Admittanz $Y_s(S)$ zuführt.

Die virtuelle Admittanz erzeugt also aus einem Spannungswert einen Stromsollwert.

Der Spannungswert setzt sich dabei bevorzugt aus einer Differenz zwischen einer virtuellen Polradspannung e* und einer am Anschlusspunkt des Umrichters gemessene Spannung $V_{PCC}$ zusammen.

Die virtuelle Polradspannung e* kann bspw. durch einen äußeren Regelkreis bereitgestellt werden, insbesondere einem äußeren Regelkreis, wie nachstehend beschrieben.

Bevorzugt ist das äußere Regelkreis dazu eingerichtet, eine virtuelle Synchronmaschine zu emulieren, insbesondere eine virtuelle Polradspannung vorzugeben bzw. zu generieren.

Die am Anschlusspunkt des Umrichters gemessene Spannung $V_{PCC}$ kann bspw. durch eine Spannungserfassung erfolgen, die bspw. dazu eingerichtet ist, die Spannungen der drei Ausgangsphasen des Umrichters zu messen. Die Spannungserfassung kann bspw. Bestandteil des Umrichters sein.

Der, durch die virtuelle Admittanz generierte Stromsollwert kann dann bspw. dazu verwendet werden, den Umrichter zu steuern, insbesondere die vom Umrichter erzeugten, bevorzugt drei, dreiphasigen Wechselströme.

Zudem wird bevorzugt eine Stromerfassung verwendet, die dazu eingerichtet ist, einen vom Umrichter erzeugten Strom, insbesondere den nachstehend beschriebenen Strom $i_g$, zu erfassen. Mittels dieses erfassten Stromes kann der Umrichter zusätzlich geregelt werden.

Vorzugsweise weist der, insbesondere innere, Regelkreis ferner eine Stromregelung auf, die dazu eingerichtet ist, aus einem ersten oder einem zweiten Stromsollwert i*, i** und einem vom Umrichter erzeugten Strom $i_g$ einen Steuerwert S zu erzeugen.

Der Regelkreis umfasst also ferner einen, insbesondere weiteren, Abgleich, der den Stromsollwert i*, i** mit einem vom Umrichter erzeugten Strom $i_g$ abgleicht, um einen Steuerwert S zu erzeugen mittels dem der Umrichter angesteuert wird.

Dieser Abgleich kann auch als Stromsteuerung bezeichnet werden.

Ist bspw. der Stromsollwert i*, i** größer als der vom Umrichter erzeugte Strom $i_g$, erhöht der Steuerwert S den vom Umrichter erzeugten Strom $i_g$, insbesondere so, dass die Differenz zwischen Stromsollwert i*, i** und den vom Umrichter erzeugten Strom $i_g$ zu Null wird.

Ist bspw. der Stromsollwert i*, i** kleiner als der vom Umrichter erzeugte Strom $i_g$, verringert der Steuerwert S den vom Umrichter erzeugten Strom, insbesondere so, dass die Differenz zwischen Stromsollwert i*, i** und den vom Umrichter erzeugten Strom $i_g$ zu Null wird.

Vorzugsweise weist der, insbesondere innere, Regelkreis ferner eine Strombegrenzung, insbesondere umfassend eine Amplituden- und/oder Stromamplitudenbegrenzung, auf, die einen ersten Stromsollwert i* auf einen zweiten Stromsollwert i** limitiert.

Es wird somit ferner auch vorgeschlagen, dass das Steuermodul eine Strombegrenzung aufweist.

Die Begrenzung wird dabei insbesondere dazu verwendet, den vom Umrichter erzeugten Strom zu begrenzen, insbesondere in seiner Amplitude.

Hierfür wird bspw. der erste Stromsollwert mittels einer Transformation, bspw. einer dq-Transformation in einen Winkel und in eine Amplitude zerlegt und anschließend in der Amplitude begrenzt.

Dies ist besonders vorteilhaft, wenn bspw. der äußere Regelkreis oder der innere Regelkreis zu einem Strom führen würden, der größer ist als eine, insbesondere Hardware-, Randbedingung des Umrichters. In solchen Fällen limitiert also die Strombegrenzung den durch den inneren Regelkreis erzeugten ersten Stromsollwert i* auf einen zweiten Stromsollwert i**.

In einer bevorzugten Ausführungsform ist die Strombegrenz parametrierbar und/oder im laufenden Betrieb einstellbar, insbesondere auf einen maximal zulässigen Stromwert, der zu einem Strom führt, der dem zweiten Stromsollwert i** entspricht.

Vorzugsweise weist die Strombegrenzung ferner eine Transformation auf, insbesondere eine dq-Transformation oder eine aß-Transformation, die den ersten Stromsollwert i* in eine Amplitude $I_{amp}$ und einen Winkel $I_{phase}$ zerlegt, insbesondere um den Stromsollwert i* in der Amplitude zu begrenzen oder eine Transformation, die den ersten Stromsollwert (i*) in Mit- und Gegensystemkomponenten zerlegt, insbesondere um den Stromsollwert (i*) in der Amplitude zu begrenzen.

Es wird somit insbesondere vorgeschlagen, nicht nur den Momentan- bzw. Augenblickswert des ersten Stromsollwert i* zu begrenzen, sondern die Amplitude des Raumzeigers.

Dies kann bspw. durch eine Transformation in aß-Koordinaten erfolgen und/oder in eine Zerlegung mittels der Methode der symmetrischen Komponenten.

Besonders vorteilhaft hierbei ist, dass durch die Transformation eine höhere Genauigkeit der Begrenzung erreicht werden kann, bei zugleich geringerem reglungstechnischen Eingriff, insbesondere da der Winkel von der Begrenzung bevorzugt unberührt bleibt.

In einer bevorzugten Ausführungsform wird also nur die Amplitude und nicht der Winkel bzw. die Phase begrenzt.

Vorzugsweise weist die Strombegrenzung ferner eine Rücktransformation auf, die dazu eingerichtet ist, aus einer bzw. der Amplitude $I_{amp}$ und einem bzw. dem Winkel $I_{phase}$, einen zweiten Stromsollwert (i**) zu bilden.

Es wird somit insbesondere auch vorgeschlagen, aus der begrenzten Amplitude $I_{amp}$ und dem Winkel $I_{phase}$ den zweiten Stromsollwert i** mittels einer Rücktransformation zu erzeugen.

In einer besonders bevorzugten Ausführungsform weist die Rücktransformation dieselbe Transformationsart, wie bspw. dq-Transformation oder aß-Transformation, auf, wie die Transformation.

Vorzugsweise weist die Strombegrenzung ferner einen Signaleingang auf, der dazu eingerichtet ist, eine Frequenz oder ein Winkelsignal eines weiteren, insbesondere äußeren Regelkreises aufzunehmen.

Es wird somit insbesondere vorgeschlagen, dass die Strombegrenzung mit einer internen Referenz, bspw. dem nachstehend beschriebenen Referenzwinkel Θ arbeitet, insbesondere um im Netzfehlerfall eine korrekte Phasenlage für den Stromsollwert, insbesondere den zweiten Stromsollwert i**, zu ermitteln.

Der Referenzwinkel Θ, der aus den äußeren Regelkreis berechnet wird, wird bspw. für die Umwandlung der Stromsollwerte i*, i** von abc Koordinaten auf dq- oder aß-Koordinaten verwendet, insbesondere um Amplitude und Phase des Raumzeigers zu berechnen.

Vorzugsweise weist die Strombegrenzung eine Komponentenzerlegung auf, die dazu eingerichtet ist, eine bzw. die Amplitude $I_{amp}$ und außerdem oder alternativ einen bzw. den Winkel $I_{phase}$ in ein Mit- und in ein Gegensystem zu zerlegen, insbesondere mittels eines internen Referenzwinkels Θ.

Es wird somit insbesondere auch vorgeschlagen, dass die Strombegrenzung im Mit- und Gegensystem arbeitet.

Besonders vorteilhaft hierbei ist, dass die Strombegrenzung auch im Falle von asymmetrischen Netzfehlern verwendet werden kann.

Vorzugsweise weist die Strombegrenzung ferner eine Komponentenvereinigung auf, die dazu eingerichtet ist, aus einen bzw. den Mitsystemwert und außerdem oder alternativ ein bzw. den Gegensystemwert einer bzw. der Amplitude $I_{amp}$ und außerdem oder alternativ eines bzw. dem Winkel $I_{phase}$ einen zweiten Stromsollwert i** zu bilden.

Es wird somit insbesondere auch vorgeschlagen, den ersten Stromsollwert i* in Mit- und Gegensystemkomponenten zu zerlegen, die Amplitude zu begrenzen und das hieraus resultierende System wieder in den zweiten Stromsollwert i** zurückzutransformieren.

Vorzugsweise weist der, insbesondere innere, Regelkreis ferner eine Admittanzregelung auf, insbesondere zum Begrenzen der Umrichterströme, die dazu eingerichtet ist, die virtuelle Admittanz $Y_s(S)$ zu verändern.

Bspw. ist die Admittanzregelung dazu eingerichtet, Werte für den ohmschen Anteil $R_{virt}$ und für den induktiven Anteil $L_{virt}$ zu berechnen und mittels derer die virtuelle Admittanz einzustellen.

Durch ein Erhöhen der virtuelle Admittanz $Y_s(S)$ können bspw. die vom Umrichter erzeugten Ströme, insbesondere im Netzfehlerfall, reduziert, bevorzugt auf einen zulässigen Wert begrenzt werden.

Vorzugsweise weist die Admittanzregelung ferner einen Komperator auf, umfassend: einen Stellwert s1 für den ohmschen Anteil $R_{virt}$ der virtuellen Admittanz $Y_s(S)$ und außerdem oder alternativ einen Stellwert s2 für den induktiven Anteil $L_{virt}$ der virtuellen Admittanz $Y_s(S)$, wobei der Stellwert s1, s2 einstellbar ist, und wobei der Komperator dazu eingerichtet ist, den Stellwert s1, s2 mit einem berechneten Wert $R_{virt\_f}$ für den ohmschen Anteil $R_{virt}$ der virtuellen Admittanz $Y_s(S)$ und außerdem oder alternativ mit einem berechneten Wert $L_{virt\_f}$ für den induktiven Anteil $L_{virt}$ der virtuellen Admittanz $Y_s(S)$ zu vergleichen.

Es wird somit insbesondere vorgeschlagen, dass der ohmschen Anteil $R_{virt}$ und der induktiven Anteil $L_{virt}$ der virtuelle Admittanz $Y_s(S)$ über einen Vergleich eingestellt werden.

Bspw. umfasst die Admittanzregelung einen Admittanzrechner zum Berechnen eines ohmschen Anteils $R_{virt\_f}$ und eines induktiven Anteils $L_{virt\_f}$

Die so berechneten Werte $R_{virt\_f}$, $L_{virt\_f}$ werden dann jeweils mit einem Stellwert s1 für den ohmschen Anteil $R_{virt}$ und einem Stellwert s2 für den induktiven Anteil $L_{virt}$ abgeglichen.

Ist dann bspw. der berechnete Wert des induktiven Anteils $L_{virt\_f}$ größer als der gesetzte Stellwert s2 für den induktiven Anteil $L_{virt}$ wird der berechnete Wert des induktiven Anteils $L_{virt\_f}$ für die virtuelle Admittanz $Y_s(S)$ verwendet.

Ist bspw. der berechnete Wert des ohmschen Anteil $R_{virt\_f}$, kleiner als der gesetzte Stellwert s1 für den ohmschen Anteil $R_{virt}$ wird der Stellwert s1 für die virtuelle Admittanz $Y_s(S)$ verwendet.

Vorzugsweise weist die Admittanzregelung ferner einen Filter auf, bevorzugt einem Kalman-Filter, der dazu eingerichtet ist, eine Netzspannungsamplitude $V_{PCC\_amp}$, insbesondere einer am Anschlusspunkt des Umrichters erfassten Spannung $V_{PCC}$, zu schätzen und außerdem oder alternativ einen Integrator, bevorzugt einem second-order generalized integrator, der dazu eingerichtet ist, eine Netzspannungsamplitude $V_{PCC\_amp}$, insbesondere einer am Anschlusspunkt des Umrichters erfassten Spannung $V_{PCC}$, zu schätzen.

Es wird somit insbesondere vorgeschlagen, dass die Admittanzregelung auf Basis der Netzspannungsamplitude $V_{PCC\_amp}$ arbeitet, die bspw. durch einen Kalmann-Filter aus der am Anschlusspunkt des Umrichters erfassten Spannung $V_{PCC}$ ermittelt wird.

Hierfür kann die Admittanzregelung bspw. einen Admittanzrechner aufweisen.

Vorzugsweise weist die Admittanzregelung einen Admittanzrechner auf, der dazu eingerichtet ist, einen berechneten Wert $R_{virt\_f}$ für den ohmschen Anteil $R_{virt}$ der virtuellen Admittanz $Y_s(S)$ und außerdem oder alternativ einen berechneten Wert $L_{virt\_}$, für den induktiven Anteil $L_{virt}$ der virtuellen Admittanz $Y_s(S)$ zu ermitteln, insbesondere unter Verwendung eines maximal zulässigen Stromes $I_{max}$ und/oder einer geschätzten Netzspannungsamplitude $V_{PCC\_amp}$ und/oder einem Amplitudenwert, insbesondere einem Wert der Amplitude der virtuellen Polradspannung entspricht.

Erfindungsgemäß wird ferner eine Steuereinheit eines Umrichters, insbesondere eines Leistungsumrichters einer Windenergieanlage, vorgeschlagen, die dazu eingerichtet ist, den Umrichter so anzusteuern, dass der Umrichter ein Verhalten einer Synchronmaschine emuliert, umfassend: einen, insbesondere äußeren, Regelkreis, zum Erzeugen eines internen Referenzwinkels Θ und/oder einer virtuellen Polradspannung e*, wenigstens aufweisend: einen Schalter, der dazu eingerichtet ist, im Falle eines Netzfehlers in einem elektrischen Versorgungsnetz geschlossen oder geöffnet zu werden, insbesondere, um einen Raumzeiger mit einer konstanten Amplitude und einem konstanten Phasenwinkel zur Verfügung zu stellen.

Die Steuereinheit weist somit wenigstens einen Schalter auf, der sobald ein Fehler erkannt wird, die Position derart wechselt, dass eine virtuelle Polradspannung der virtuellen Synchronmaschine in einem Raumzeiger mit konstanter Amplitude und Phasenwinkel zur Verfügung gestellt wird.

Diese virtuelle Polradspannung kann dann bspw. als Polradspannung e* dienen, insbesondere für einen vorstehend oder nachstehen beschriebenes Steuermodul, insbesondere für einen bzw. den inneren Regelkreis.

Vorzugsweise wird der Raumzeiger als Eingangssignal eines Steuermoduls verwendet, welches einen Steuerwert erzeugt, um den Umrichter zu steuern.

Vorzugsweise ist das Steuermodul ein vorstehend oder nachstehend beschriebenes Steuermodul.

Erfindungsgemäß wird ferner ein Verfahren zum Steuern eines Umrichters, insbesondere einer Windenergieanlage, vorgeschlagen, umfassend die Schritte: Erfassen einer Spannung $V_{PCC}$ an einem Anschlusspunkt des Umrichters, Vorgeben einer virtuellen Polardspannung e*, Vorgeben einer virtuellen Admittanz $Y_s(S)$, Berechnen eines Steuerwertes S, insbesondere eines Stromsteuerwertes, in Abhängigkeit der am Anschlusspunkt des Umrichters erfassten Spannung $V_{PCC}$, der virtuellen Polradspannung e* und der virtuellen Admittanz $Y_s(S)$ und Steuern des Umrichters in Abhängigkeit des Steuerwertes S.

Vorzugsweise wird der Steuerwert S aus einem Stromsollwert i*, i** berechnet, wobei das Verfahren ferner den Schritt umfasst: Begrenzen des Stromsollwertes i* mit einer Strombegrenzung.

Vorzugsweise erfolgt dies unter Verwendung eines vorstehend oder nachstehend beschriebenen Steuermoduls oder einer vorstehend oder nachstehend beschriebenen Steuereinheit.

Erfindungsgemäß wird ferner ein Umrichter, insbesondere einer Windenergieanlage, vorgeschlagen, umfassend wenigstens eine Steuereinheit, insbesondere wie vorstehend oder nachstehend beschrieben, wobei die Steuereinheit dazu eingerichtet ist, den Umrichter so unter Verwendung einer virtuellen Admittanz anzusteuern, dass der Umrichter wenigstens ein Verhalten einer Synchronmaschine emuliert.

In einer bevorzugten Ausführungsform ist der Umrichter als Wechselrichter ausgeführt und dazu eingerichtet, einen dreiphasigen Strom in ein dreiphasiges Netz, bspw. ein Windparknetz oder ein elektrisches Versorgungsnetz einzuspeisen.

Der Umrichter kann ferner modularisiert ausgeführt sein, also mehrere, parallele Umrichtermodule und/oder Wechselrichtermodule aufweisen.

Bevorzugt ist der Umrichter, ein Umrichter eines regenerativen Erzeugers, wie bspw. einer Windenergie- oder einer PV-Anlage, oder eines Energiespeichers oder eines FACTS, insbesondere STATCOM oder UPFC, der dazu eingerichtet ist, einen dreiphasigen Strom in ein elektrisches Netz einzuspeisen.

Erfindungsgemäß wird ferner eine Windenergieanlage vorgeschlagen, umfassend ein vorstehend oder nachstehend beschriebenes Steuermodul und/oder eine vorstehend oder nachstehend beschriebene Steuereinheit und/oder einen vorstehend oder nachstehend beschriebenen Umrichter und/oder umfassend eine Steuereinheit eines Umrichters, die dazu eingerichtet ist, ein vorstehend oder nachstehend beschriebenes Verfahren auszuführen.

Die vorliegende Erfindung wird nun nachfolgend exemplarisch anhand von Ausführungsbeispielen unter Bezugnahme auf die begleitenden Figuren näher erläutert, wobei fürgleich oder ähnliche Baugruppen dieselben Bezugszeichen verwendet werden.

Fig. 1     zeigt eine schematische Ansicht einer Windenergieanlage gemäß einer Ausführungsform.

Fig. 2     zeigt eine schematische Ansicht einer Windenergieanlage an einem Anschlusspunkt gemäß einer Ausführungsform.

Fig. 3     zeigt ein Steuermodul eines Umrichters gemäß einer Ausführungsform.

Fig. 4     zeigt ein Steuermodul eines Umrichters gemäß einer weiteren Ausführungsform mit einer Strombegrenzung.

Fig. 5     zeigt ein Steuermodul eines Umrichters gemäß einer bevorzugten Ausführungsform mit einer Admittanzregelung.

Fig. 6     zeigt ein Steuermodul eines Umrichters gemäß einer bevorzugten Ausführungsform mit einer weiteren Strombegrenzung.

Fig. 7     zeigt ein Steuermodul eines Umrichters gemäß einer bevorzugten Ausführungsform mit einer bevorzugten Strombegrenzung, insbesondere für unsymmetrische Netzfehler.

Fig. 7A     zeigt ein Steuermodul eines Umrichters gemäß einer bevorzugten Ausführungsform mit einer bevorzugten Strombegrenzung, insbesondere für unsymmetrische Netzfehler, umfassend eine Korrektur.

Fig. 7B     zeigt ein Steuermodul eines Umrichters gemäß einer bevorzugten Ausführungsform mit einer bevorzugten Strombegrenzung, insbesondere für unsymmetrische Netzfehler, umfassend eine Korrektur in einer alternativ Ausgestalung.

Fig.8     zeigt eine Steuereinheit eines im Umrichters in einer bevorzugten Ausführungsform.

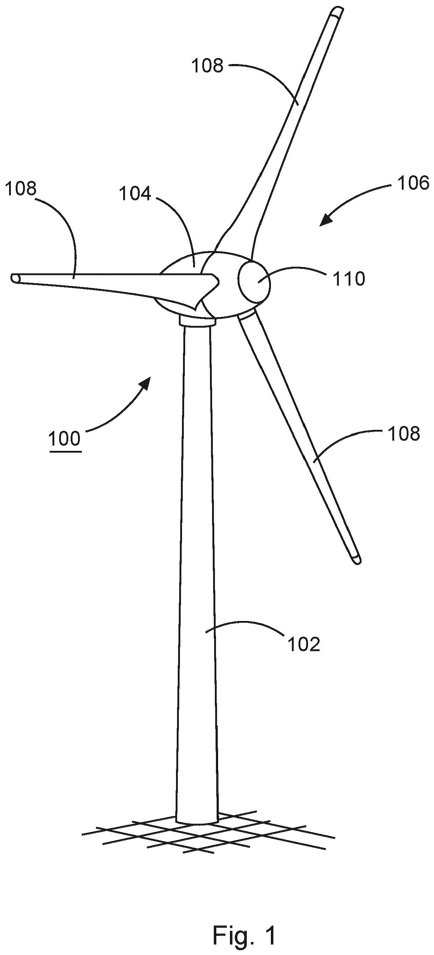

Fig. 1 zeigt eine schematische Ansicht einer Windenergieanlage 100 gemäß einer Ausführungsform.

Die Windenergieanlage 100 weist hierzu einen Turm 102 und eine Gondel 104 auf. An der Gondel 104 ist ein aerodynamischer Rotor 106 mit drei Rotorblättern 108 und einem Spinner 110 angeordnet. Der Rotor 106 wird im Betrieb durch den Wind in eine Drehbewegung versetzt und treibt dadurch einen Generator in der Gondel 104 an.

Der Generator ist mittels eines Umrichters an ein elektrisches Netz, bspw. ein Windparknetz oder ein elektrisches Versorgungsnetz, angeschlossen, um einen dreiphasigen Wechselstrom einzuspeisen.

Die Windenergieanlage umfasst hierfür ein vorstehend oder nachstehend beschriebenes Steuermodul und/oder eine vorstehend oder nachstehend beschriebene Steuereinheit und/oder einen vorstehend oder nachstehend beschriebenen Umrichter und/oder eine Steuereinheit eines Umrichters, die dazu eingerichtet ist, ein vorstehend oder nachstehend beschriebenes Verfahren auszuführen.

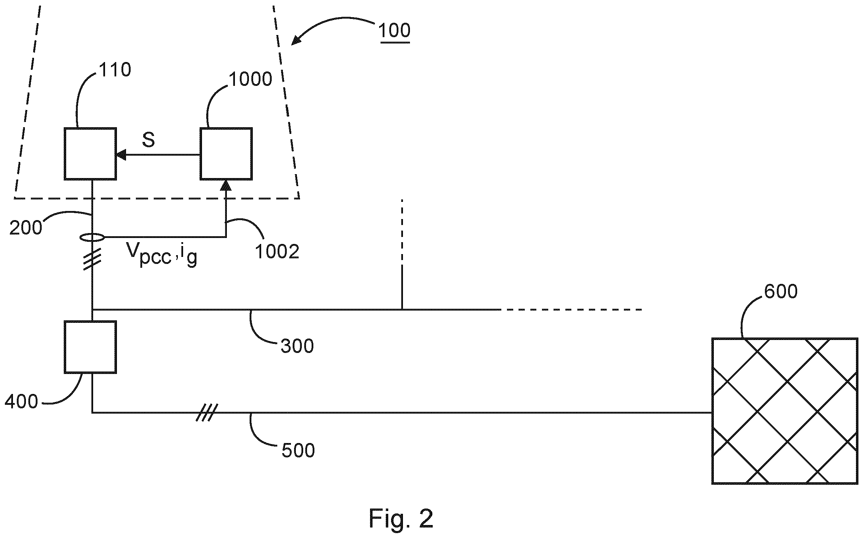

Fig. 2 zeigt eine schematische Ansicht einer Windenergieanlage 100 an einem Anschlusspunkt 200 gemäß einer Ausführungsform.

Die Windenergieanlage 100 weist einen Wechselrichter 110 und eine Steuereinheit 1000 auf.

Die Steuereinheit 1000 ist dazu eingerichtet, ein vorstehend oder nachstehend beschriebenes Verfahren auszuführen und insbesondere den Wechselrichter 110 so mittels des Steuerwertes S anzusteuern, dass dieser eine Synchronmaschine emuliert.

Hierzu weist die Steuereinheit 1000 unter anderem eine Spannungserfassung und/oder Stromerfassung 1002 auf, die dazu eingerichtet ist, eine erste Spannung einer ersten Phase, eine zweite Spannung einer zweiten Phase und eine dritte Spannung einer dritten Phase zu erfassen, insbesondere der drei Phasen des Windparknetzes 300 und/oder den vom Umrichter erzeugten Strom $i_g$.

Der vom Umrichter 110 erzeugte Strom $i_g$ wird an dem Anschlusspunkt PCC bspw. in ein Windparknetz 300 eingespeist, welches mehrere Windenergieanlagen miteinander verbindet.

Das Windparknetz 300 ist ferner über einen Transformator 400 und eine Verbindungsleitung 500 mit einem elektrischen Versorgungsnetz 600 verbunden.

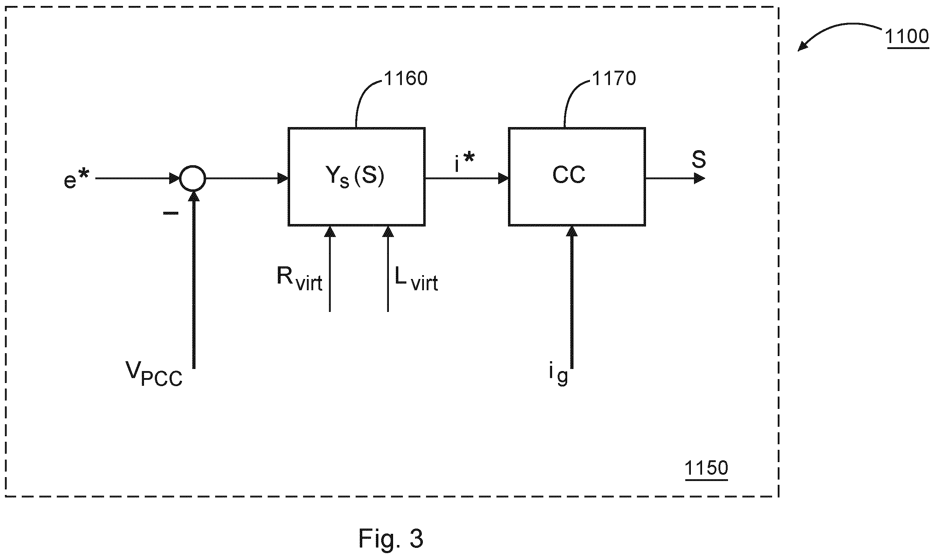

Fig. 3 zeigt ein Steuermodul 1100 eines Umrichters 110 gemäß einer Ausführungsform.

Das Steuermodul 1100 umfasst einen inneren Regelkreis 1150, der eine einstellbare, virtuelle Admittanz 1160 aufweist, mittels derer der Umrichter angesteuert wird, um das Verhalten der Synchronmaschine zu emulieren.

Die virtuelle Admittanz 1160, die auch als $Y_s(S)$ bezeichnet werden kann, ist definiert als:

$$Y_s(S) = \frac{1}{Z_{virt}(S)} = \frac{1}{R_{virt} + s\, L_{virt}},$$

wobei $Z_{virt}(S)$ eine virtuelle Impedanz ist und $R_{virt}$ ein entsprechender ohmscher Anteil der virtuellen Impedanz ist und $L_{virt}$ ein entsprechender induktiver Anteil der virtuellen Impedanz ist und s ein Laplace-Operator ist.

Bevorzugt wird die virtuelle Admittanz mittels dem ohmscher Anteil der virtuellen Impedanz $R_{virt}$ und/oder dem induktiver Anteil der virtuellen Impedanz $L_{virt}$ im laufenden Betrieb des Umrichters eingestellt, insbesondere wie vorstehend oder nachstehend beschrieben.

Mittels eines Spannungsabgleichs, aus einer Differenz zwischen einer virtuellen Polradspannung e* und einer am Anschlusspunkt des Umrichters gemessene Spannung $V_{PCC}$ bildet die virtuellen Admittanz 1160 einen ersten Stromsollwert i*.

Dieser Stromsollwert i* wird mittels einer Stromregelung 1170 in einen Steuerwert S umgewandelt, insbesondere um den Umrichter anzusteuern.

Die Stromregelung 1170 ist also insbesondere dazu eingerichtet, aus einem ersten Stromsollwert i* und einem vom Umrichter erzeugten Strom $i_g$ einen Steuerwert S zu erzeugen, bspw. in oder mittels abc-Koordinaten $i^*_a$, $i^*_b$, $i^*_c$.

Die Stromregelung 1170 vergleicht dabei insbesondere den Stromsollwert i* mit einem vom Umrichter erzeugten Strom $i_g$ , um einen Steuerwert S zu erzeugen mittels dem der Umrichter angesteuert wird. Der Strom $i_g$ kann dabei bspw. mit einem Hysterese-Regelverfahren, bspw. einem Toleranzbandverfahren, mittels abc-Koordinaten erzeugt werden, die dazu verwendet werden die Pulse der IGBTs des Umrichters zu steuern.

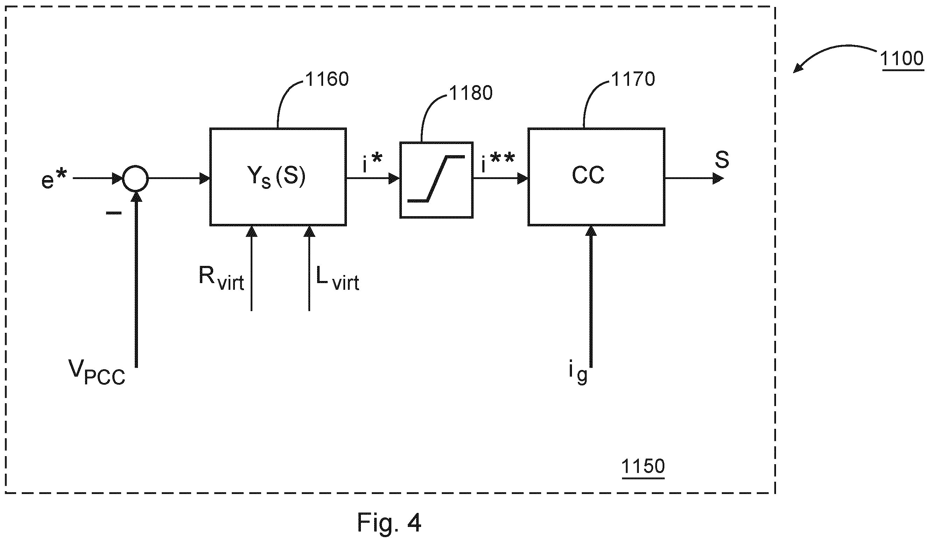

Fig. 4 zeigt ein Steuermodul 1100 eines Umrichters, insbesondere wie in Fig. 3 gezeigt, gemäß einer weiteren Ausführungsform mit einer Strombegrenzung 1180.

Das Steuermodul 1100 weist im inneren Regelkreis 1150 eine Strombegrenzung 1180 auf, die zwischen der virtuellen Admittanz 1160 und der Stromregelung 1170 angeordnet ist.

Die Strombegrenzung ist somit ebenfalls Bestandteil des inneren Regelkreises und bevorzugt dazu eingerichtet, den ersten Stromsollwert i*, der von der virtuellen Admittanz 1160 erzeugt wird, auf einen zweiten Stromsollwert i** zu limitieren, bspw. durch Vorgabe von einem Strommaximum und/oder einem Stromminimum für den Stromsollwert i*.

Die Stromregelung 1170 ist somit auch dazu eingerichtet, aus einem zweiten Stromsollwert i** und einem vom Umrichter erzeugten Strom $i_g$ einen bzw. den Steuerwert S zu erzeugen.

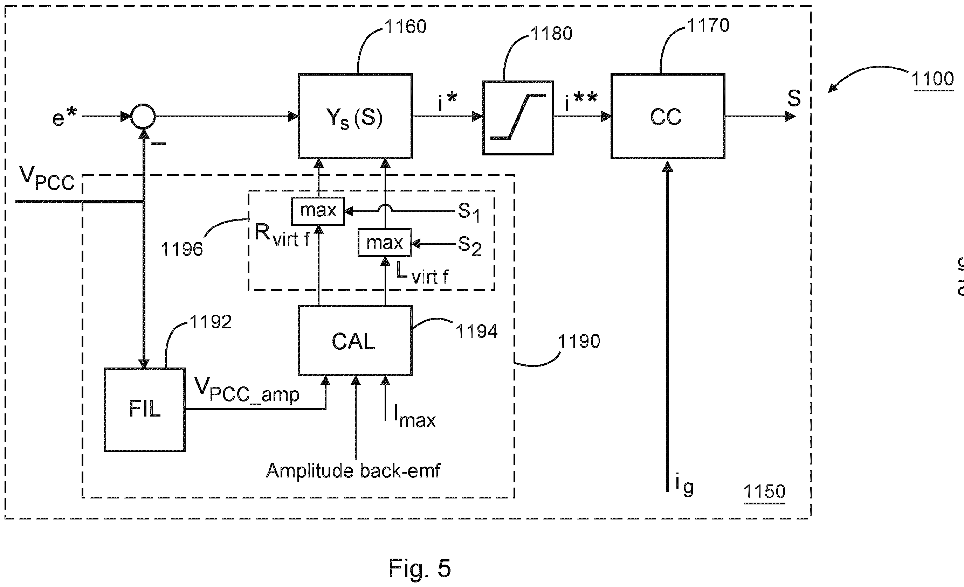

Fig. 5 zeigt ein Steuermodul 1100 eines Umrichters, insbesondere wie in Fig. 4 gezeigt, gemäß einer weiteren Ausführungsform mit Admittanzregelung 1190.

Das Steuermodul 1100 weist im inneren Regelkreis 1150 zudem eine Admittanzregelung 1190 auf, die dazu eingerichtet ist, die virtuelle Admittanz $Y_s(S)$ zu verändern bzw. einzustellen.

Mittels der Admittanzregelung 1190 kann insbesondere die Admittanz $Y_s(S)$ erhöht werden, um die Umrichterströme zu begrenzen.

Hierfür umfasst die Admittanzregelung 1190 einen Filter- und/oder Integrator-Block 1192, der dazu eingerichtet, die am Anschlusspunkt erfasste Spannung $V_{PCC}$ zu filtern und/oder zu schätzen.

Bevorzugt weist der Filter- und/oder Integrator-Block 1192 hierfür einen Kalman-Filter auf, der dazu eingerichtet ist, eine Netzspannungsamplitude $V_{PCC\_amp}$, insbesondere einer am Anschlusspunkt des Umrichters erfassten Spannung $V_{PCC}$, zu schätzen.

Außerdem oder alternativ weist der Filter- und/oder Integrator-Block 1192 bevorzugt einen Integrator auf, bevorzugt einem second-order generalized integrator, der dazu eingerichtet ist, eine Netzspannungsamplitude $V_{PCC\_amp}$, insbesondere einer am Anschlusspunkt des Umrichters erfassten Spannung $V_{PCC}$, zu schätzen.

Die durch den Filter- und/oder Integrator-Block 1192 ermittelte Netzspannungsamplitude $V_{PCC\_amp}$ wird einem Admittanzrechner 1194 zugeführt.

Der Admittanzrechner 1194 ist dazu eingerichtet ist, einen berechneten Wert $R_{virt\_f}$ für den ohmschen Anteil $R_{virt}$ der virtuellen Admittanz $Y_s(S)$ und außerdem oder alternativ einen berechneten Wert $L_{virt\_f}$ für den induktiven Anteil $L_{virt}$ der virtuellen Admittanz $Y_s(S)$ zu ermitteln, insbesondere unter Verwendung eines maximal zulässigen Stromes $I_{max}$ und/oder einer geschätzten Netzspannungsamplitude $V_{PCC\_amp}$ und/oder einem weiteren Amplitudenwert, der insbesondere der virtuellen Polradspannung (virtual back-emf) entspricht..

Die so berechneten Werte $R_{virt\_f}$, $L_{virt\_f}$ werden dann an einen Komperator übergeben.

Der Komperator 1194 umfasst einen Stellwert s1 für den ohmschen Anteil $R_{virt}$ der virtuellen Admittanz $Y_s(S)$ und außerdem einen Stellwert s2 für den induktiven Anteil $L_{virt}$ der virtuellen Admittanz $Y_s(S)$, wobei die Stellwerte s1, s2 bevorzugt einstellbar sind.

Zudem ist der Komperator dazu eingerichtet ist, die Stellwert s1, s2 mit dem berechneten Wert $R_{virt\_f}$ für den ohmschen Anteil $R_{virt\_}$ der virtuellen Admittanz $Y_s(S)$ und außerdem mit dem berechneten Wert $L_{virt\_f}$ für den induktiven Anteil $L_{virt}$ der virtuellen Admittanz $Y_s(S)$ zu vergleichen.

Das Ergebnis dieses Vergleiches wird anschließend dazu verwendet die virtuellen Admittanz $Y_s(S)$ entsprechend der Gleichung:

$$Y_s(S) = \frac{1}{Z_{virt}(S)} = \frac{1}{R_{virt} + s\, L_{virt}}$$

Es wird also insbesondere vorgeschlagen im Normalbetrieb des Umrichters die Werte des ohmschen Anteils $R_{virt}$ und des induktiven Anteils $L_{virt}$ vorzugeben.

Zudem ist ein zusätzlicher Block, die Admittanzregelung 1190, vorgesehen, der anhand des Augenblickswert der Spannungsamplitude $V_{PCC\_amp}$, der Amplitude der Polradspannung und der maximalen Amplitude des Umrichterstroms $I_{max}$ die Augenblickswerte für die jeweiligen Anteile der virtuellen Impedanz, nämlich für den ohmschen Anteil $R_{virt\_f}$ und für den induktiven Anteil $L_{virt\_f}$ berechnet, insbesondere für die Begrenzung der Ströme. Diese Werte sind in Fig. 5 als $R_{virt\_f}$ und $L_{virt\_f}$ bezeichnet, und entsprechen im Normalbetrieb relativ kleinen Werten, die erst relevant für die Berechnung der virtuellen Admittanz in dem Moment werden, wenn ein Fehler erkannt wurde und deren Amplituden die von den Nennwerten $R_{virt}$ und $L_{virt}$ überschreitet.

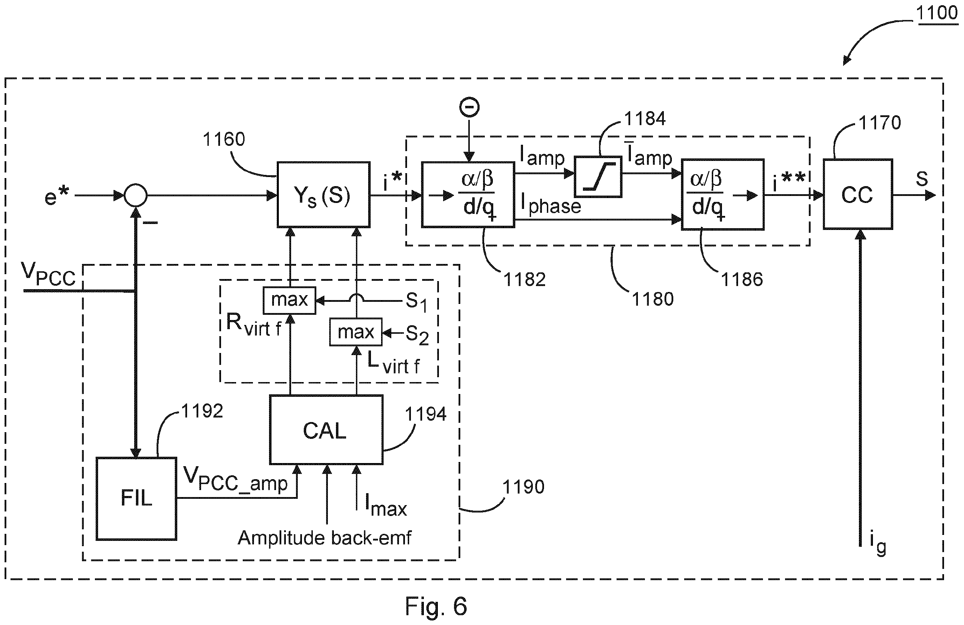

Fig. 6 zeigt ein Steuermodul 1100 eines Umrichters, insbesondere wie in Fig.5 gezeigt, gemäß einer weiteren Ausführungsform mit einer weiteren Strombegrenzung 1180.

Die Strombegrenzung 1180 umfasst eine Transformation 1182, eine Amplitudenbegrenzung 1184 und eine Rücktransformation 1186.

Die Transformation 1182 ist bspw. eine dq-Transformation oder eine aß-Transformation, die dazu eingerichtet ist, einen bzw. den ersten Stromsollwert i* in eine Amplitude $I_{amp}$ und einen Winkel $I_{phase}$ zu zerlegen, insbesondere um den Stromsollwert i* in der Amplitude zu begrenzen.

Die eigentliche Begrenzung der Amplitude $I_{amp}$ erfolgt dann durch die Amplitudenbegrenzung 1184, die auch als Stromamplitudenbegrenzung bezeichnet werden kann.

Die Amplitudenbegrenzung 1184 begrenzt somit die Amplitude $I_{amp}$ des ersten Stromsollwertes i* auf eine maximal zulässige Amplitude $\overline{I}_{amp}$.

Anschließend werden der Winkel $I_{phase}$ und die maximal zulässige Amplitude $\overline{I}_{amp}$ mittels der Rücktransformation 1186 in einen zweiten Stromsollwert i** transformiert.

Der zweite Stromsollwert ** wird dann der Stromregelung CC zugeführt.

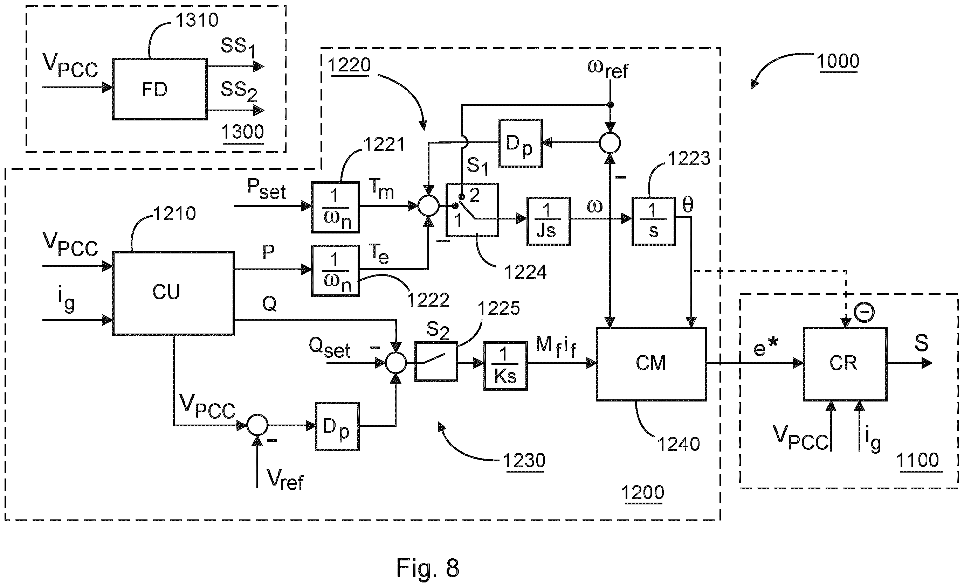

Zur Optimierung wird ferner ein interner Referenzwinkel Θ verwendet, welcher bspw. durch einen äußeren Regelkreis berechnet wird, wie bspw. in Fig. 8 dargestellt.

Der interne Referenzwinkel Θ wird insbesondere bei der Transformation verwendet, insbesondere um bei der Transformation eine genauere Amplitude und einen genaueren Winkel zu erhalten.

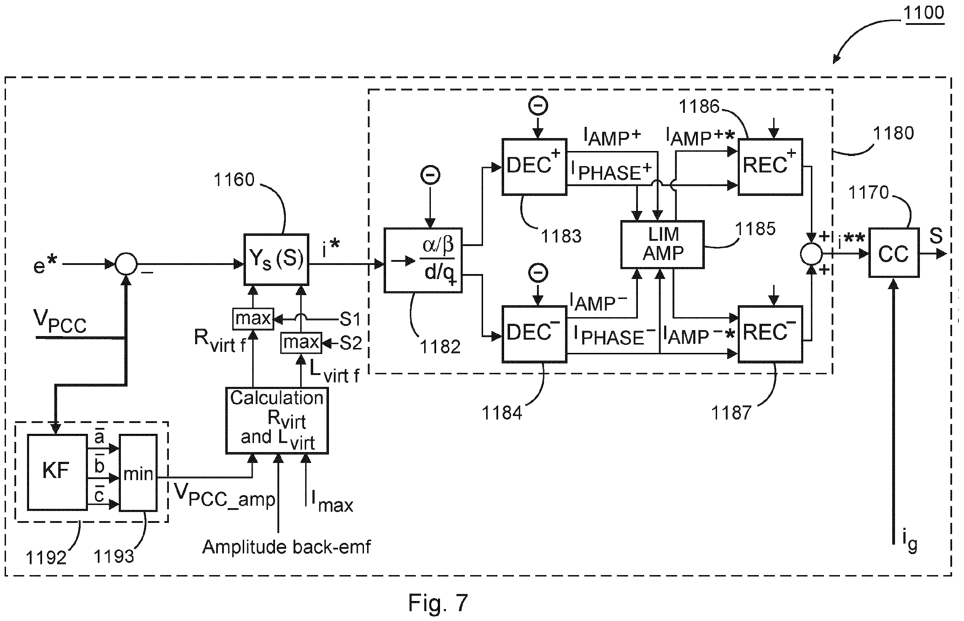

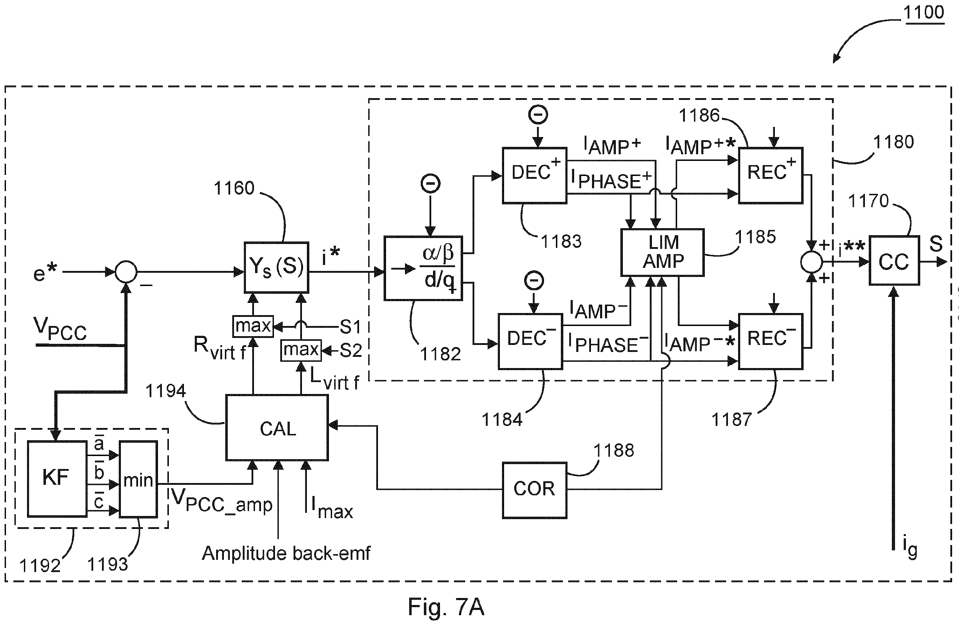

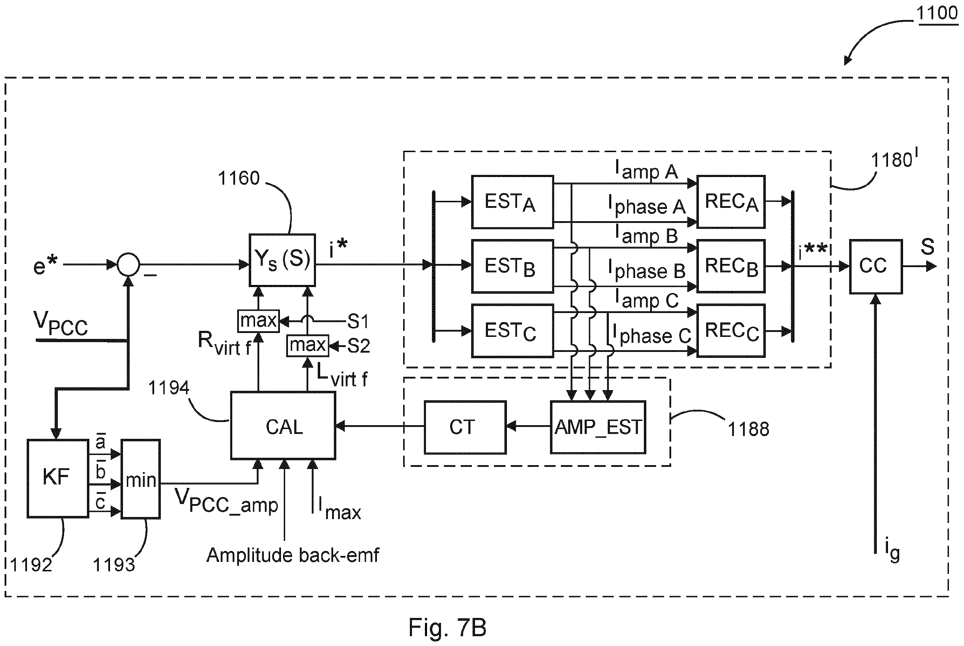

Fig. 7 zeigt ein bevorzugte Ausführungsform eines Steuermoduls eines Umrichters, insbesondere wie in Fig. 6, gemäß einerweiteren Ausführungsform mit einer bevorzugten Strombegrenzung, insbesondere für unsymmetrische Netzfehler.

Beim Auftreten von unsymmetrischen Netzfehlern kann es dazu kommen, dass der Umrichter asymmetrisch belastet wird. Dies wiederum führt dazu, dass jede Phase eine andere Stromamplitude aufweist.

Um unterschiedlichen Amplituden unterschiedlicher Phasen gezielt zu begrenzen wird daher vorgeschlagen, den Filter- und/oder Integrator-Block 1192 phasengenau arbeiten zulassen.

Der Filter- und/oder Integrator-Block 1192 weist hierfür bspw. eine Kalman-Filter KF auf, der die einzelnen Amplituden der Spannungen der Phasen a,b,c schätzt.

Die so geschätzten Werte werden mittels eines Vergleichsoperator 1193 verglichen, wobei der niedrigsten Augenblickswert dann für die Berechnung der virtuellen Admittanz $Y_s(S)$ verwendet wird, insbesondere wie vorstehend oder nachstehend beschrieben.

Ferner umfasst die Strombegrenzung 1180 neben der Transformation 1182, die eine Transformation in Mit- und Gegensystem vornimmt, bspw. durch eine aß-Transformation, eine Zerlegungseinheit für das Mitsystem 1183, eine Zerlegungseinheit für das Gegensystem 1184, eine Amplitudenlimitierung 1185, eine Rekonstruktion für das Mitsystem 1186 und eine Rekonstruktion für das Gegensystem.

Es wird also insbesondere vorgeschlagen sowohl die Amplitude als auch den Winkel mittels der Zerlegungseinheiten 1183, 1184 in Mit- und Gegensystemkomponenten zu zerlegen, dann die Amplitude mittels der Amplitudenlimitierung 1185 zu begrenzen und anschließend die daraus erhaltenen Komponenten mittels der Rekonstruktionen 1186, 1187 in den zweiten Stromsollwert i** umzuwandeln.

Die Zerlegung erfolgt dabei bevorzugt in eine Stromamplitude des Mitsystems $I_{AMP}^+$, eine Stromamplitude des Gegensystems $I_{AMP}^-$, einen Phasenwinkel des Mitsystems $I_{PHASE}^+$ und einen Phasenwinkel des Gegensystem $I_{PHASE}^-$.

Der zweite Stromsollwert ** wird dann der Stromregelung CC zugeführt.

Zur weiteren Optimierung wird der Referenzwinkel Θ, welcher bspw. durch einen äußeren Regelkreis berechnet wird, wie bspw. in Fig. 8 dargestellt, auch bei der Zerlegung in Mit- und Gegensystem berücksichtigt.

Besonders vorteilhaft hierbei ist, dass sowohl bei der Transformation als auch bei der Zerlegung derselbe interne Referenzwinkel verwendet wird, wodurch keine Synchronisierungseinheit zwischen Transformation 1182 und Zerlegung 1183, 1184 notwendig ist.

Fig. 7A zeigt eine weitere Ausführung eines Steuermoduls, wie in Fig. 7 gezeigt.

Das Steuermodul 1100 umfasst zusätzlich eine Korrektur 1188, die zwischen der Amplitudenlimitierung 1185 und dem Admittanzrechner 1194 angeordnet ist, insbesondere in Form eines feedback-loops.

Die Korrektur 1188 umfasst bspw. eine Amplitudenbestimmung und einen Korrekturfaktor.

Da die Berechnung der virtuellen Admittanz anhand von den Amplituden der gemessenen Netzspannung und der virtuellen Polradspannung erfolgt, insbesondere um die maximalen Ströme des Umrichters begrenzen zu können, ist ein genauer Phasenwinkel der Netzspannung von Vorteil. Hierfür ist die Korrektur 1188 vorgesehen. Wenn die Amplituden der Umrichterströme nach Anpassung der virtuellen Admittanz den maximalen Wert noch überschreiten sollte, wird durch die Korrektur 1188 die Amplitude der virtuellen Admittanz dementsprechend korrigiert, insbesondere um die Stromsollwerte unter deren maximalen Wert begrenzen zu können. Fig. 7A zeigt eine weitere Ausführung eines Steuermoduls, wie in Fig. 7 gezeigt, in einer alternativen Ausgestaltung.

Das Steuermodul 1100 weist die in Fig. 7A beschriebene Korrektur 1188 auf, die eine Amplitudenbestimmung AMP_EST und einen Korrekturfaktor CT umfasst.

Die Strombegrenzung 1180' weist eine alternative Ausgestaltung zu der Strombegrenzung 1180 in Fig. 7 auf.

Die Strombegrenzung 1180' ist mittels der drei Phasenbestimmungen $EST_A$. $EST_B$, $EST_C$ und der drei Rekonstruktionen $REC_A$, $REC_B$, $REC_C$ dazu eingerichtet, die Stromsollwerte als einphasige Ströme zu betrachten. Hierfür werden bspw. die einzelnen Amplituden und Winkel von den jeweiligen Phasen geschätzt, insbesondere mittels eines Kalman-Filters geschätzt, um die endgültigen Stromsollwerte des Umrichters zu berechnen.

Der Vorteil gegenüber den vorherigen Varianten liegt darin, dass die resultierenden Sollwerte des dreiphasigen Systems nicht in Mit- und Gegensystemkomponenten zerlegt werden müssen.

Fig.8 zeigt eine Steuereinheit 1000 eines im Umrichters, insbesondere eines Umrichters 110 wie in Fig. 2 gezeigt, in einer bevorzugten Ausführungsform.

Die Steuereinheit umfasst ein vorstehend oder nachstehend beschriebenes Steuermodul 1100, insbesondere umfassend einen inneren Regelkreis, einen äußeren Regelkreis 1200 zum Erzeugen eines internen Referenzwinkels $\Theta$ und einer virtuellen Polradspannung e* und eine Schaltvorrichtung 1300.

Das Steuermodul 1100 ist vorstehend oder nachstehend beschrieben aufgebaut und dazu eingerichtet, einen Steuerwert S zum Ansteuern eines Umrichters zu erzeugen, insbesondere in Abhängigkeit einer virtuellen Polradspannung e*, eines internen Referenzwinkel $\Theta$, einer am Anschlusspunkt des Umrichters erfassten Spannung $V_{PCC}$ und einem erfassten, vom Umrichter erzeugten Strom $i_g$.

Hierfür werden die Spannung $V_{PCC}$ am Anschlusspunkt des Umrichters und der vom Umrichter erzeugte Strom $i_g$ erfasst, bspw. durch die vorstehend oder nachstehend beschriebene Spannungs- und/oder Stromerfassung.

Der äußere Regelkreis 1200 umfasst hierfür eine Berechnungseinheit 1210, einen Wirkleistungspfad 1220, einen Blindleistungspfad 1230 und Recheneinheit 1240, wobei der Wirkleistungspfad auch als Wirkleistungsschleife (engl. active power loop) und der Blindleistungspfad auch als Blindleistungsschleife (engl. re-active power loop) bezeichnet werden können. Der äußere Regelkreis 1200 weist also zwei separate Pfade auf, nämlichen einen für die Wirkleistung und einen für die Blindleistung.

Die Berechnungseinheit 1210 ist dazu eingerichtet, aus der am Anschlusspunkt des Umrichters erfassten Spannung $V_{PCC}$ und dem erfassten, vom Umrichter erzeugten Strom $i_g$ eine Wirkleistung P und eine Blindleistung Q zu berechnen.

Die Wirkleistung P dient als Eingangsgröße für den Wirkleistungspfad 1220.

Die Blindleistung Q dient als Eingangsgröße für den Blindleistungspfad 1230.

Der Wirkleistungspfad ist dazu eingerichtet, aus einem Wirkleistungssollwert $P_{SET}$, der bspw. durch eine Windenergieanlagensteuerung vorgegeben wird und der, von der Berechnungseinheit 1210 berechneten Wirkleistung P eine Winkelgeschwindigkeit $\omega$ und einen internen Referenzwinkel $\Theta$ zu berechnen.

Hierzu wird zunächst aus dem Wirkleistungssollwert $P_{SET}$ ein Generatorsolldrehmoment $T_m$ ermittelt, bspw. mittels einer ersten Verstärkung 1221 und aus der, von der Berechnungseinheit 1210 berechneten Wirkleistung P ein Generatoristdrehmoment $T_e$, bspw. mittels einer zweiten Verstärkung 1222.

Aus diesen beiden Wertet $T_m$, $T_e$ wird unter Berücksichtigung einer Referenzwinkelgeschwindigkeit $\omega_{ref}$ eine Differenzwinkelgeschwinkeit $\omega$ ermittelt. Die Referenzwinkelgeschwindigkeit kann entweder ein fester Wert sein (z. B. Nennfrequenz), oder im Betrieb aktualisiert werden und den Wert vor der Störung darstellen.

Aus der Differenzwinkelgeschwinkeit $\omega$ wird dann unter Verwendung einer Verstärkung der interne Referenzwinkel $\Theta$ ermittelt.

Der interne Referenzwinkel $\Theta$ dient als Eingangsgröße für die Recheneinheit 1240.

Der Blindleistungspfad 1230 ist dazu eingerichtet, aus einem Blindleistungssollwert $Q_{SET}$, der bspw. durch eine Windenergieanlagensteuerung vorgegeben wird und der, von der Berechnungseinheit 1210 berechneten Blindleistung Q eine Korrelationsgröße $M_{if}$ zu bestimmen, insbesondere unter Verwendung einer Referenzspannung $V_{ref}$. Die Korrelationsgröße Mfif bildet dabei insbesondere die Kopplung zwischen Stator und Rotor ab.

Sowohl der Wirkleistungspfad 1220 als auch der Blindleistungspfad 1230 weisen jeweils einen Schalter S1, S2.

Die Schalter S1 und S2 werden bspw. durch die Fehlererkennung 1310 ausgelöst.

Der Schalter S1 ist dabei so innerhalb des Wirkleistungspfades 1220 angeordnet, dass der Wirkleistungspfad 1220 beim Auslösen des Schalter S1 nur noch die Referenzwinkelgeschwinkeit $\omega_{ref}$ und den internen Referenzwinkel $\Theta$, der aus Referenzwinkelgeschwinkeit $\omega_{ref}$ ermittelt wurde, an die Recheneinheit 1240 übergibt.

Der Schalter S2 ist dabei so innerhalb des Blindleistungspfades 1230 angeordnet, dass der Blindleistungspfad 1230 beim Auslösen des Schalter S2 keine Wert mehr an die Recheneinheit 1240 übergibt.

Es wird also insbesondere vorgeschlagen, dass der äußere Regelkreis im Fehlerfall eine virtuelle Polradspannung e* mit konstanter Amplitude ausgibt, und bevorzugt mit einem konstanten Winkel und einer konstanten Winkelgeschwindigkeit.

Die Recheneinheit 1240 ist ferner dazu eingerichtet, aus einer bzw. der Korrelationsgröße Mfif, insbesondere der Blindleistungspfades 1230, einer bzw. der Winkelgeschwindigkeit $\omega$ und einem bzw. dem internen Referenzwinkel $\Theta$, eine virtuelle Polradspannung e* zu berechnen.

Die Fehlererkennung 1300 ist dazu eingerichtet, aus der am Anschlusspunkt erfassten Spannung $V_{PCC}$ zu ermitteln, ob eine Fehlerfall vorliegt, bspw. eine Asymmetrie in dem Netz, an das der Umrichter angeschlossen ist, und daraus entsprechende Schaltersignale SS1, SS2 zu bestimmen, mittels derer die Schalter S1, S2 angesteuert werden.

Es wird also insbesondere für den äußeren Regelkreis vorgeschlagen, dass beim Auftreten eines Netzfehlers, der bspw. durch eine Fehlererkennung 1300 erkannt wurde, die Schalter S1, S2 derart in ihrer Stellung geändert, insbesondere geöffnet werden, dass dadurch eine Polradspannung mit einer konstanten Amplitude und einem konstanten Phasenwinkel erzeugt wird.

Mit anderen Worten wird vorgeschlagen, dass in einem Fehlerfall eine konstante Polrandspannung verwendet wird.

Um hierdurch auftretende, virtuelle Statorströme zu begrenzen, kann der vorstehend oder nachstehend beschriebene, innere Regelkreis CR verwendet werden, insbesondere das Steuermodul 1100.

**Patentansprüche**

1. Steuermodul eines Umrichters, insbesondere eines Leistungsumrichters einer Windenergieanlage, das dazu eingerichtet ist, den Umrichter so anzusteuern, dass der Umrichter ein Verhalten einer Synchronmaschine emuliert, umfassend:

    - einen, insbesondere inneren, Regelkreis, der eine, insbesondere einstellbare, virtuelle Admittanz aufweist, mittels derer der Umrichter angesteuert wird, um das Verhalten der Synchronmaschine zu emulieren.

2. Steuermodul eines Umrichters, insbesondere eines Leistungsumrichters einer Windenergieanlage, nach Anspruch 1, wobei

    - die virtuelle Admittanz $Y_s(S)$ definiert ist als:

$$Y_s(S) = \frac{1}{Z_{virt}(S)} = \frac{1}{R_{virt} + s\, L_{virt}},$$

wobei $Z_{virt}(S)$ eine virtuelle Impedanz ist und $R_{virt}$ ein entsprechender ohmscher Anteil der virtuellen Impedanz ist und $L_{virt}$ ein entsprechender induktiver Anteil der virtuellen Impedanz ist und s ein Laplace-Operator ist.

3. Steuermodul eines Umrichters, insbesondere eines Leistungsumrichters einer Windenergieanlage, nach Anspruch 1 oder 2, wobei

    - die virtuelle Admittanz ($Y_s(S)$) einen ersten Stromsollwert (i*) erzeugt.

4. Steuermodul eines Umrichters, insbesondere eines Leistungsumrichters einer Windenergieanlage, nach einem der vorstehenden Ansprüche, wobei der, insbesondere innere, Regelkreis ferner aufweist:

    - einen Spannungsabgleich, der eine Differenz zwischen einer virtuellen Polradspannung (e*) und einer am Anschlusspunkt des Umrichters gemessene Spannung ($V_{PCC}$) bildet, und die Differenz der virtuellen Admittanz ($Y_s(S)$) zuführt.

5. Steuermodul eines Umrichters, insbesondere eines Leistungsumrichters einer Windenergieanlage, nach einem der vorstehenden Ansprüche, wobei der, insbesondere innere, Regelkreis ferner aufweist:

    - eine Stromregelung, die dazu eingerichtet ist, aus einem ersten oder einem zweiten Stromsollwert i*, i** und einem vom Umrichter erzeugten Strom $i_g$ einen Steuerwert S zu erzeugen.

6. Steuermodul eines Umrichters, insbesondere eines Leistungsumrichters einer Windenergieanlage, nach einem der vorstehenden Ansprüche, wobei der, insbesondere innere, Regelkreis ferner aufweist:

    - eine Strombegrenzung, insbesondere umfassend eine Amplituden- und/oder Stromamplitudenbegrenzung, aufweist, die einen ersten Stromsollwert (i*) auf einen zweiten Stromsollwert (i**) limitiert.

7. Steuermodul eines Umrichters, insbesondere eines Leistungsumrichters einer Windenergieanlage, nach Anspruch 6, wobei die Strombegrenzung ferner aufweist:

- eine Transformation, insbesondere eine dq-Transformation oder eine aß-Transformation, die den ersten Stromsollwert (i*) in eine Amplitude ($I_{amp}$) und einen Winkel ($I_{phase}$) zerlegt, insbesondere um den Stromsollwert (i*) in der Amplitude zu begrenzen oder

- eine Transformation, die den ersten Stromsollwert (i*) in Mit- und Gegensystemkomponenten zerlegt, insbesondere um den Stromsollwert (i*) in der Amplitude zu begrenzen.

8. Steuermodul eines Umrichters, insbesondere eines Leistungsumrichters einer Windenergieanlage, nach Anspruch 6 oder 7, wobei die Strombegrenzung ferner aufweist:

- eine Rücktransformation, die dazu eingerichtet ist aus einer bzw. der Amplitude ($I_{amp}$) und einem bzw. dem Winkel ($I_{phase}$), einen zweiten Stromsollwert (i**) zu bilden.

9. Steuermodul eines Umrichters, insbesondere eines Leistungsumrichters einer Windenergieanlage, nach einem der Ansprüche 6 bis 8, wobei die Strombegrenzung ferner aufweist:

- einen Signaleingang, der dazu eingerichtet ist, eine Frequenz oder ein Winkelsignal eines weiteren, insbesondere äußeren Regelkreises aufzunehmen.

10. Steuermodul eines Umrichters, insbesondere eines Leistungsumrichters einer Windenergieanlage, nach einem der Ansprüche 6 bis 9, wobei die Strombegrenzung ferner aufweist:

- eine Komponentenzerlegung, die dazu eingerichtet ist, eine bzw. die Amplitude ($I_{amp}$) und außerdem oder alternativ einen bzw. den Winkel ($I_{phase}$) in ein Mit- und in ein Gegensystem zu zerlegen, insbesondere mittels eines internen Referenzwinkels ($\Theta$).

11. Steuermodul eines Umrichters, insbesondere eines Leistungsumrichters einer Windenergieanlage, nach einem der Ansprüche 6 bis 10, wobei die Strombegrenzung ferner aufweist:

- eine Komponentenvereinigung, die dazu eingerichtet ist, aus einen bzw. den Mitsystemwert und außerdem oder alternativ ein bzw. den Gegensystemwert einer bzw. der Amplitude $I_{amp}$ und außerdem oder alternativ eines bzw. dem Winkel $I_{phase}$ einen zweiten Stromsollwert (i**) zu bilden.

12. Steuermodul eines Umrichters, insbesondere eines Leistungsumrichters einer Windenergieanlage, nach einem der vorstehenden Ansprüche, wobei der, insbesondere innere, Regelkreis ferner aufweist:

- eine Admittanzregelung, insbesondere zum Begrenzen der Umrichterströme, die dazu eingerichtet ist, die virtuelle Admittanz $Y_s(S)$ zu verändern.

13. Steuermodul eines Umrichters, insbesondere eines Leistungsumrichters einer Windenergieanlage, nach Anspruch 12, wobei die Admittanzregelung ferner aufweist:

- einen Komperator umfassend:
- einen Stellwert (s1) für den ohmschen Anteil $R_{virt}$ der virtuellen Admittanz $Y_s(S)$ und außerdem oder alternativ
- einen Stellwert (s2) für den induktiven Anteil $L_{virt}$ der virtuellen Admittanz $Y_s(S)$, wobei
- der Stellwert (s1, s2) einstellbar ist, wobei
- der Komperator dazu eingerichtet ist, den Stellwert (s1, s2) mit einem berechneten Wert $R_{virt\_f}$ für den ohmschen Anteil $R_{virt\_}$ der virtuellen Admittanz $Y_s(S)$ und außerdem oder alternativ mit einem berechneten Wert $L_{virt\_f}$ für den induktiven Anteil $L_{virt}$ der virtuellen Admittanz $Y_s(S)$ zu vergleichen.

14. Steuermodul eines Umrichters, insbesondere eines Leistungsumrichters einer Windenergieanlage, nach Anspruch 12 oder 13, wobei die Admittanzregelung ferner aufweist:

- einen Filter, bevorzugt einem Kalman-Filter, der dazu eingerichtet ist, eine Netzspannungsamplitude $V_{PCC\_amp}$, insbesondere einer am Anschlusspunkt des Umrichters erfassten Spannung $V_{PCC}$, zu schätzen und außerdem oder alternativ
- einen Integrator, bevorzugt einem second-ordergeneralized integrator, der dazu eingerichtet ist, eine Netzspannungsamplitude $V_{PCC\_amp}$, insbesondere einer am Anschlusspunkt des Umrichters erfassten Spannung $V_{PCC}$, zu schätzen.

15. Steuermodul eines Umrichters, insbesondere eines Leistungsumrichters einer Windenergieanlage, nach Anspruch 12 bis 14, wobei die Admittanzregelung ferner aufweist:

- Admittanzrechner, der dazu eingerichtet ist, einen berechneten Wert $R_{virt\_f}$ für den ohmschen Anteil $R_{virt}$ der virtuellen Admittanz $Y_s(S)$ und außerdem oder alternativ einen berechneten Wert $L_{virt\_f}$ für den induktiven Anteil $L_{virt}$ der virtuellen Admittanz $Y_s(S)$ zu ermitteln, insbeson-

dere unter Verwendung eines maximal zulässigen Stromes $I_{max}$ und/oder einer geschätzten Netzspannungsamplitude $V_{PCC\_amp}$ und/oder einem Amplitudenwert.

16. Steuereinheit eines Umrichters, insbesondere eines Leistungsumrichters einer Windenergieanlage, die dazu eingerichtet ist, den Umrichter so anzusteuern, dass der Umrichter ein Verhalten einer Synchronmaschine emuliert, umfassend:

- einen, insbesondere äußeren, Regelkreis, zum Erzeugen eines internen Referenzwinkels ($\Theta$) und/oder einer virtuellen Polradspannung ($e^*$), wenigstens aufweisend:

- einen Schalter, der dazu eingerichtet ist, im Falle eines Netzfehlers in einem elektrischen Versorgungsnetz geschlossen oder geöffnet zu werden, insbesondere, um einen Raumzeiger mit einer konstanten Amplitude und einem konstanten Phasenwinkel zur Verfügung zu stellen.

17. Steuereinheit eines Umrichters, insbesondere eines Leistungsumrichters einer Windenergieanlage, wobei der Raumzeiger als Eingangssignal eines Steuermoduls verwendet wird, welches einen Steuerwert erzeugt, um den Umrichter zu steuern.

18. Steuereinheit eines Umrichters, insbesondere eines Leistungsumrichters einer Windenergieanlage, nach Anspruch 16 oder 17, wobei das Steuermodul ein Steuermodul nach einem der Ansprüche 1 bis 15 ist.

19. Verfahren zum Steuern eines Umrichters, insbesondere einer Windenergieanlage, umfassend die Schritte:

- Erfassen einer Spannung $V_{PCC}$ am Anschlusspunkt des Umrichters,
- Vorgeben einer virtuellen Polardspannung $e^*$,
- Vorgeben einer virtuellen Admittanz $Y_s(S)$,
- Berechnen eines Steuerwertes S, insbesondere eines Stromsteuerwertes, in Abhängigkeit der am Anschlusspunkt des Umrichters erfassten Spannung $V_{PCC}$, der virtuellen Polardspannung $e^*$ und der virtuellen Admittanz $Y_s(S)$,
- Steuern des Umrichters in Abhängigkeit des Steuerwertes S.

20. Verfahren zum Steuern eines Umrichters, insbesondere einer Windenergieanlage, wobei

- der Steuerwert S aus einem Stromsollwert $i^*$, $i^{**}$ berechnet wird, ferner umfassend den Schritt:

- Begrenzen des Stromsollwertes $i^*$ mit einer Strombegrenzung.

21. Verfahren zum Steuern eines Umrichters, insbesondere einer Windenergieanlage, unter Verwendung eines Steuermoduls nach einem der Ansprüche 1 bis 15 oder einer Steuereinheit nach einem der Ansprüche 16 oder 17.

22. Umrichter, insbesondere einer Windenergieanlage, umfassend wenigstens eine Steuereinheit, insbesondere umfassend ein Steuermodul nach einem derAnsprüche 1 bis 15, wobei die Steuereinheit dazu eingerichtet ist, den Umrichter so unter Verwendung einer virtuellen Admittanz anzusteuern, dass der Umrichter wenigstens ein Verhalten einer Synchronmaschine emuliert.

23. Windenergieanlage umfassend ein Steuermodul nach einem der Ansprüche 1 bis 15 und/oder eine Steuereinheit nach Anspruch 16 oder 17 und/oder einen Umrichter nach Anspruch 22 und/oder umfassend eine Steuereinheit eines Umrichters, die dazu eingerichtet ist, ein Verfahren nach einem der Schritte 19 bis 21 auszuführen.

Fig. 1

Fig. 2

Fig. 3

EP 3 836 337 A1

Fig. 4

EP 3 836 337 A1

Fig. 5

EP 3 836 337 A1

Fig. 6

Fig. 7

Fig. 7A

Fig. 7B

Fig. 8

Europäisches Patentamt
European Patent Office
Office européen des brevets

## EUROPÄISCHER TEILRECHERCHENBERICHT

nach Regel 62a und/oder 63 des Europäischen Patentübereinkommens. Dieser Bericht gilt für das weitere
Verfahren als europäischer Recherchenbericht.

**Nummer der Anmeldung**

EP 20 20 5955

### EINSCHLÄGIGE DOKUMENTE

| Kategorie | Kennzeichnung des Dokuments mit Angabe, soweit erforderlich der maßgeblichen Teile | Betrifft Anspruch | KLASSIFIKATION DER ANMELDUNG (IPC) |
|---|---|---|---|
| X | EP 2 683 077 A1 (ABENGOA SOLAR NEW TECH SA [ES]) 8. Januar 2014 (2014-01-08) | 1-5,23 | INV. H02J3/38 H02P21/00 |
| Y | * Absätze [0002] - [0035] * | 6-15,20, 21 | |
| | ----- | | |
| X | EP 2 683 076 A1 (ABENGOA SOLAR NEW TECH SA [ES]) 8. Januar 2014 (2014-01-08) | 1,19 | |
| Y | * Absätze [0002] - [0018] * | 20,21 | |
| | ----- | | |
| Y,D | WO 2019/129864 A1 (SIEMENS AG [DE]) 4. Juli 2019 (2019-07-04) * Seite 12, Zeile 12 - Seite 13, Zeile 22 * | 6-15,20, 21 | |
| | ----- | | |

**RECHERCHIERTE SACHGEBIETE (IPC)**

H02J
H02P

### UNVOLLSTÄNDIGE RECHERCHE

Die Recherchenabteilung ist der Auffassung, daß ein oder mehrere Ansprüche, den Vorschriften des EPÜ nicht entspricht bzw. entsprechen, so daß nur eine Teilrecherche (R.62a, 63) durchgeführt wurde.

Vollständig recherchierte Patentansprüche:

Unvollständig recherchierte Patentansprüche:

Nicht recherchierte Patentansprüche:

Grund für die Beschränkung der Recherche:

Siehe Ergänzungsblatt C

| Recherchenort | Abschlußdatum der Recherche | Prüfer |
|---|---|---|
| München | 23. April 2021 | Berger, Josef |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04E09)

Europäisches
Patentamt

European
Patent Office

Office européen
des brevets

**UNVOLLSTÄNDIGE RECHERCHE
ERGÄNZUNGSBLATT C**

**Nummer der Anmeldung**

**EP 20 20 5955**

Vollständig recherchierbare Ansprüche:
1-15, 19, 20

Unvollständig recherchierte Ansprüche:
21, 23

Nicht recherchierte Ansprüche:
16-18, 22

Grund für die Beschränkung der Recherche:

1.1        In Erwiderung auf die Einladung der Recherchenabteilung, einen unabhängigen Vorrichtungsanspruch und einen unabhängigen Verfahrenanspruch anzugeben, reichte die Anmelderin mit Schreiben vom 20.04.2021 neue Patentansprüche 1-23 ein.
Diese neu formulierten Ansprüche gelten nicht als geänderte Ansprüche im Sinne von Regel 137 (1), sondern lediglich als Erläuterungen zum ursprünglich eingereichten Anspruchssatz.
Diese Ansprüche werden erst dann formell in das Verfahren eingeführt, wenn innerhalb der Fristen nach Regel 70 (1) und (2) eine entsprechende Erklärung des Anmelders beim EPA eingeht.
Alle Ausführungen in diesem Bescheid beziehen sich auf die ursprünglich eingereichten Ansprüche.
1.1        Die Anmelderin erbat eine Prüfung der neu eingereichten Ansprüche 1, 16, 19, 22, schwieg sich jedoch darüber aus, welche Ansprüche recherchiert werden sollten. Die Angabe der Anmelderin wird daher derart interpretiert, dass sie eine Recherche der neu eingereichten Ansprüche 1, 16, 19, 22 erbete und dass Ansprüche 20 und 21 als abhängige Ansprüche zu sehen seien.
1.2        Die neu eingereichten Ansprüche 1, 16, 19, 22 sind identisch mit den ursprünglich eingereichten Ansprüchen 1, 16, 19, 22.
1.3        Die Anmelderin trug in ihrem Schreiben vor, sie vertrete die Auffassung, dass Anspruch 23 als abhängiger Anspruch zu sehen sei. Die Recherchenabteilung kann diese Auffassung nicht vollumfänglich teilen. Anspruch 23 beinhaltet mindestens 4 Alternativen. Jede dieser Alternativen und deren Kombinationen, stellt de facto einen unabhängigen Anspruch dar. Im Einzelnen wird beansprucht:
1.4        Eine Windenergieanlage, umfassend:
a) Ein Steuermodul nach einem der Ansprüche 1-15
b) Eine Steuereinheit nach Anspruch 16 oder 17
c) Einen Umrichter nach Anspruch 22
d) Eine Steuereinheit, die eingerichtet ist, ein Verfahren nach einem der Schritte 19 bis 21 auszuführen
1.1        Die Alternativen mit Merkmale a) - c) und deren Kombination sind abhängige Ansprüche. Die Alternative mit Merkmal d) hingegen ist als unabhängiger Anspruch anzusehen, da er sich gänzlich auf Merkmale einer anderen Kategorie bezieht (RL [2021], F-IV.3.8).
1.2        Die Anmelderin trug keine Argumente vor, warum die unabhängigen Vorrichtungsansprüche 1, 16, 22 sowie Alternative d) von Anspruch 23 den Erfordernissen der R. 43(2) EPÜ entsprächen.
1.3        Anspruch 1 bezieht sich auf das Steuermodul eines Umrichters. Anspruch 16 bezieht sich auf eine Steuereinheit eines Umrichters . Anspruch 22 bezieht sich auf einen Umrichter, der Rückbezug auf einen der Ansprüche 1 bis 15 ist rein fakultativ genannt. Somit ist Anspruch 22

**UNVOLLSTÄNDIGE RECHERCHE**
**ERGÄNZUNGSBLATT C**

Europäisches Patentamt
European Patent Office
Office européen des brevets

**Nummer der Anmeldung**

EP 20 20 5955

auch als unabhängiger Anspruch anzusehen.

Anspruch 23 Alternative d) bezieht sich auf eine Steuereinheit.

1.1 Der beanspruchte Gegenstand fällt aus den folgenden Gründen nicht unter eine der in Regel 43 (2) Buchstaben a, b oder c EPÜ genannten Ausnahmesituationen (RL [2021], F-IV.3.2).

R. 43(2) a): Beim Anspruchsgegenstand handelt es sich nicht jeweils um mehrere miteinander in Beziehung stehende Erzeugnisse im Sinne eines "Sender" - "Empfänger" oder "Steckdose" - "Stecker" Prinzips, da die Anspruchsgegenstände keine Relationen zueinander aufweisen.

R. 43(2) b): Eine verschiedenartige Verwendung der jeweiligen Vorrichtung kann nicht ausgemacht werden. Somit greift die Ausnahme b) ebenfalls nicht.

R. 43 (2) c): Zwischen Ansprüchen 1 und 16 kann keine bestimmte Aufgabe ausgemacht werden, für die jeweils eine Alternativlösung bereitgestellt werden würde, insbesondere da Anspruch 16 zusätzlich das Merkmal eines Schalters aufweist, welcher im Falle eines Netzfehlers geschlossen oder geöffnet werden kann. Anspruch 1 hingegen weißt keine Merkmale auf, welche einen Bezug zur der Aufgabe des Netzfehlers herstellen würde. Ansprüche 22 und 23 Alternative d) beanspruchen jeweils andere Vorrichtung die ebenfalls keinen Bezug zur der Aufgabe des Netzfehlers aufweisen.

1.1 Die unabhängigen Ansprüche 20 und 21 werden gemäß der Eingabe der Anmelderin als abhängige Ansprüche interpretiert.

1.2 Da die oben genannten unabhängigen Ansprüche den Erfordernissen der R. 43(2) EPÜ nicht genügen, wurde die Recherche auf den Gegenstand der jeweils ersten unabhängigen Ansprüche pro Kategorie und deren abhängige Ansprüche beschränkt.

1.3 Konkret wurde somit der Gegenstand folgender Ansprüche recherchiert: Ansprüche 1-15, 19, 20, 21 in Abhängigkeit von Ansprüchen 1-15, 23 Alternative a).

**ANHANG ZUM EUROPÄISCHEN RECHERCHENBERICHT
ÜBER DIE EUROPÄISCHE PATENTANMELDUNG NR.**

EP 20 20 5955

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

23-04-2021

| Im Recherchenbericht angeführtes Patentdokument | Datum der Veröffentlichung | Mitglied(er) der Patentfamilie | Datum der Veröffentlichung |
|---|---|---|---|
| EP 2683077 A1 | 08-01-2014 | AU 2012222318 A1 | 24-10-2013 |
| | | BR 112013021813 A2 | 25-10-2016 |
| | | CL 2013002452 A1 | 18-08-2014 |
| | | CN 103548250 A | 29-01-2014 |
| | | EP 2683077 A1 | 08-01-2014 |
| | | ES 2402467 A1 | 03-05-2013 |
| | | JP 6277469 B2 | 14-02-2018 |
| | | JP 2014509179 A | 10-04-2014 |
| | | US 2014049228 A1 | 20-02-2014 |
| | | WO 2012117131 A1 | 07-09-2012 |
| EP 2683076 A1 | 08-01-2014 | EP 2683076 A1 | 08-01-2014 |
| | | ES 2402465 A1 | 03-05-2013 |
| | | US 2014049233 A1 | 20-02-2014 |
| | | WO 2012117133 A1 | 07-09-2012 |
| WO 2019129864 A1 | 04-07-2019 | CN 109995069 A | 09-07-2019 |
| | | DE 112018006628 T5 | 29-10-2020 |
| | | US 2020403414 A1 | 24-12-2020 |
| | | WO 2019129864 A1 | 04-07-2019 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20140049228 A1
- US 20140049233 A1
- GB 2554954 A
- WO 2019129864 A1

**In der Beschreibung aufgeführte Nicht-Patentliteratur**

- **R. ROSSO ; J. CASSOLI ; G. BUTICCHI ; S. ENGELKEN ; M. LISERRE.** Robust stability analysis of LCL filter based synchronverter under different grid conditions. *IEEE Trans. Power Electron.,* 2018
- **L. MARIN et al.** Stability Analysis of a Grid-Connected VSC Controlled by SPC. *7th International Conference on Renewable Energy Research and Applications, Paris,* 2018, 1209-1214
- **WEIYI ZHANG et al.** Start-Up of Virtual Synchronous Machine: Methods and Experimental Comparison. *2nd IEEE Conference on Energy Internet Internet and Energy System Integration (EI2), Beijing,* 2018, 1-9
- **ROBERTO ROSSO et al.** Robust stability analysis of LCL filter based synchronverter under different grid conditions. *IEEE Transactions on Power Electronics (T-PEL),* 2019, vol. 34, 5842-5853